# EUROPÄISCHE PATENTSCHRIFT

(11) **EP 2 026 375 B1**
(45) Veröffentlichungstag und Bekanntmachung des Hinweises auf die Patenterteilung: **11.06.2014**
(21) Anmeldenummer: 08170182.3
(22) Anmeldetag: 13.08.2000
(51) Int. Cl.: H01J 37/32

(54) **Elektrische Versorgungseinheit für Plasmaanlagen**
Electrical supply unit for plasma systems
Ensemble d'alimentation électrique pour systèmes à plasma

(30) Priorität: 13.08.1999 DE 19937859
(43) Veröffentlichungstag der Anmeldung: 18.02.2009
(62) Teilanmeldung aus: 00965751.1
(73) Patentinhaber: TRUMPF Hüttinger GmbH + Co. KG, 79111 Freiburg im Breisgau (DE)
(72) Erfinder: Zähringer, Gerhard, 79112, Freiburg (DE); Wiedemuth, Peter, 79336, Herbolzheim (DE); Rettich, Thomas, 79108, Freiburg (DE)
(74) Vertreter: Lohr, Georg

(56) Entgegenhaltungen:
- EP-A- 1 013 792
- WO-A-97/49267
- DE-A1- 4 239 218
- DE-A1- 19 623 654
- US-A- 5 303 139
- US-A- 5 682 067

## Beschreibung

### Technisches Gebiet

Die Erfindung bezieht sich auf eine elektrische Versorgungseinheit für Plasmaanlagen, wie Plasma-Bearbeitungs- bzw. Beschichtungsvorrichtungen, bei denen es zum Auftreten von Lichtbögen bzw. Durchschlägen (Arcs) insbesondere zwischen den Elektroden kommen kann, gemäß dem Oberbegriff der unabhängigen Patentansprüche.

Plasmaanlagen, für die die gattungsgemäßen elektrischen Versorgungseinheiten bestimmt sind, haben eine Vielzahl von Anwendungsmöglichkeiten und werden beispielsweise zum Besputtern von Targets eingesetzt. In der Regel haben sie eine elektrische Leistung in der Größenordnung von ca. einigen kW bis zu mehr als 100 kW. Die an die Elektroden angelegte Betriebsspannung liegt dabei typischerweise in der Größenordnung von 400 V. Selbstverständlich sind dabei Abweichungen nach oben oder unten - auch in Abhängigkeit von der Anwendung - möglich.

Insbesondere beim sogenannten "reaktiven" Sputtern, das zum Beispiel zur Herstellung von Oxid- oder Nitrid-Filmen verwendet wird, oder bei der Verwendung reaktiver Gase ergeben sich Probleme durch das Auftreten von Durchschlägen und/oder die Bildung isolierender Schichten auf dem leitenden Target, durch die sich parasitäre Kondensatoren ausbilden können.

### Stand der Technik

Es sind die verschiedensten passiven und aktiven Schaltungen bekannt, die zum Löschen von Lichtbögen dienen, die sich aufgrund von Durchschlägen gebildet haben. Allen diesen Schaltungen ist gemeinsam, daß für einen bestimmten Zeitraum die an die Elektroden angelegte Spannung abgeschaltet wird. Nur exemplarisch wird hierzu auf die US-PSen 4,692,230, 5,009,764, 5,015,493 und 5,682,067 verwiesen, auf die im übrigen zur Erläuterung aller hier nicht näher beschrieben Einzelheiten und Anwendungsmöglichkeiten ausdrücklich Bezug genommen wird.

Die US-PS 5,682,067 beschreibt im übrigen den Stand der Technik, von dem bei der Formulierung des Oberbegriffs der unabhängigen Patentansprüche ausgegangen worden ist.

Nachteilig bei den aus diesen Druckschriften bekannten Schaltungen ist, daß nach dem Wiedereinschalten der Betriebsspannung das System eine vergleichsweise lange Zeit benötigt, um wieder mit "voller Leistung sputtern" oder das Target in anderer Weise bearbeiten zu können.

Entsprechendes gilt, wenn das System in einem sogenannten asymmetrischen Pulsbetrieb betrieben wird, um die Bildung von isolierenden Schichten auf dem Target zu verhindern.

Weiterhin ist es bekannt, die an die Elektroden angelegte Spannung periodisch - unabhängig davon ob ein Durchschlag oder ein Lichtbogen auftritt - für einen kurzen Zeitraum abzuschalten. Bei dieser Vorgehensweise muß die Einschaltdauer so gewählt werden, daß während der Zeit, während der die Spannung angelegt ist, kein Durchschlag bzw. kein Lichtbogen auftritt. Damit kann zwar das Auftreten von Durchschlägen bzw. Lichtbögen verhindert werden, durch das periodische Abschalten und das anschließende Wiederanlegen der Spannung wird die Effizienz der Anlage jedoch deutlich reduziert.

In der DE 43 39 218 A1 ist eine Anordnung zur Vermeidung von Überschlägen in Plasmakammern offenbart. Eine Stromversorgung ist fest mit einer Plasmakammer verbunden. Durch einen über einen Schalter zuschaltbaren elektrischen Energiespeicher kann die Spannung an der Plasmakammer kurzzeitig abgeschaltet werden.

Die US 5,303,139 A offenbart eine niederfrequente, gepulste, bipolare Stromversorgung durch eine Plasmakammer. Es wird hier mit einer Vollbrückenschaltung aus vier Leistungshalbleitern eine gepulste Wechselspannung zur Versorgung erzeugt.

### Darstellung der Erfindung

Der Erfindung liegt die Aufgabe zugrunde, eine elektrische Versorgungseinheit für Plasmaanlagen anzugeben, bei der die Effizienzverringerung durch das Auftreten von Lichtbögen bzw. Durchschlägen beispielsweise durch das "prophylaktische" Abschalten der Betriebsspannung möglichst gering ist und der lichtbogen wesentlich Schneller als bei einer passiven Schaltung gelöscht wird.

Erfindungsgemäße Lösungen dieser Aufgabe sind in den Patentansprüchen 1 bzw. 12 angegeben. Weiterbildungen der Erfindung sind Gegenstand der abhängigen Ansprüche.

Erfindungsgemäß wird von einer elektrischen Versorgungseinheit ausgegangen, die eine Gleichspannungs- bzw. Gleichstromquelle, deren Ausgangsanschlüsse über wenigstens eine Induktivität und einen Leistungsschalter mit den Elektroden der Plasmaanlage verbunden sind, und gegebenenfalls eine Schaltung zum Erkennen von Lichtbögen bzw. Durchschlägen aufweist, die beim Auftreten eines Lichtbogens bzw. eines Durchschlags den Schalter derart betätigt, daß keine elektrische Energie mehr an die Elektroden angelegt wird.

Ausgehend von einer derartigen, bekannten Versorgungseinheit besteht die Erfindung zum einen darin, daß der Schalter ein Serienschalter ist.

Aufgrund dieser Ausbildung arbeitet die erfindungsgemäße Versorgungseinheit wie folgt:

Der Schalter, der die an die Elektroden angelegte elektrische Leistung schaltet (im folgenden auch als Leistungsschalter bezeichnet), öffnet beim Erkennen eines Lichtbogens den Stromfluß zwischen der Gleichspannungsquelle und den Elektroden, und es erfolgt ein Umschalten der an die Elektroden angelegen Spannung auf eine Inverspannung für eine bestimmte Zeitdauer (Ausschaltdauer).

Als Schalter können selbstverständlich die unterschiedlichsten Leistungsschalter verwendet werden. Im Hinblick auf die hohe Leistung ist es jedoch bevorzugt, wenn der Schalter ein IGBT ist.

Auch als Netzteil können die unterschiedlichsten Netzteile eingesetzt werden, ebenfalls im Hinblick auf die hohe Leistung ist es jedoch bevorzugt, wenn die Gleichspannungsquelle ein Schaltregler-Netzteil ist.

In diese Falle ist es von Vorteil, wenn zwischen die Anschlüsse der Gleichspannung- bzw. Gleichstromquelle ein Kondensator geschaltet ist. Dieser Kondensator dient zur Vermeidung von Spannungsspitzen, die durch die Zuleitungsinduktivitäten in der Versorgungseinheit auftreten können. Weiterhin wird dieser Kondensator in der Zeit, in der der Leistungsschalter abgeschaltet ist, auf die volle Leerlaufspannung aufgeladen, so daß beim Durchschalten des Leistungsschalters die volle Spannungen zum Zünden des Plasmas zur Verfügung steht.

Die erfindungsgemäße Versorgungseinheit läßt sich für die verschiedensten Plasmaanlagen einsetzen, wie beispielsweise Plasmaanlagen, bei denen die eine Elektrode wenigstens eine in einer Plasmakammer angeordnete Kathode aufweist, und die andere Elektrode das Gehäuse der Plasmakammer ist. Die erfindungsgemäße Versorgungseinheit hat darüberhinaus den besonderen Vorteil, daß es auch für Plasmaanlagen verwendbar ist, bei denen wenigstens zwei voneinander getrennte Kathoden vorgesehen sind, von denen jede über einen Serienschalter mit der mit einer Freilaufdiode beschalteten Induktivität an dem einen Anschluß der Gleichspannungsquelle verbunden ist.

Bei derartigen Systemen kann beispielsweise zwischen den Kathoden alternierend umgeschaltet werden. Dies hat den Vorteil, daß Lichtbögen, die an der einen Kathode "im Entstehen" sind, zuverlässig in dem vergleichsweise langen Zeitraum gelöscht werden, während dem auf die andere Kathode umgeschaltet wird. Selbstverständlich ist es aber auch möglich, gleichzeitig von mehreren Kathoden zu sputtern.

Bei einer Weiterbildung der Erfindung ist zwischen die Elektrodenanschlüsse bzw. die Elektrodenpaare eine Diode geschaltet. Die Funktion dieser Diode wird im folgenden erläutert:

Beim Öffnen des Leistungsschalters polt die Spannung an den Zuleitungsinduktivitäten zur Plasmakammer um, so daß sich ohne weitere Schaltungsmaßnahmen Spannungsspitzen ergeben würden. Die zwischen die Elektrodenanschlüsse geschaltete Diode schließt diese Spannung kurz, so daß die in den Zuleitungsinduktivitäten gespeicherte Energie abgebaut wird.

Weiterhin ist es möglich, ein LC-Glied parallel zu der Diode zu schalten, das als passives Element die Löschung des Lichtbogens unterstützt.

Besonders bevorzugt ist es jedoch, wenn die Löschung des Lichtbogens durch aktive Schaltungselemente unterstützt wird:

Hierzu kann in Reihe mit der Diode ein Kondensator geschaltet sein. Zwischen Kathodenanschluß und den Verbindungspunkt Diode/Kondensator ist dann ein weiterer Serienschalter geschaltet. Durch diesen Schaltungsaufbau wird die sich aus der Leitungsinduktivität und dem fließenden Strom ergebende Energie beim Öffnen des Leistungsschalters als Spannung in den Kondensator umgeladen. Nach einer kurzen Verzögerung wird diese Spannung über den weiteren Serienschalter an die Elektroden angelegt, so daß der Lichtbogen wesentlich schneller als bei einer passiven Schaltung gelöscht wird.

Um auch bei kleinen Leitungsinduktivitäten oder kleinen Strömen eine entsprechend große invertierte Spannung zum Löschen zu erhalten, kann ferner eine Inversspannungsquelle vorgesehen werden.

Diese Inversspannungsquelle kann insbesondere eine (Hilfs)-Gleichspannungsquelle sein, deren Minuspol mit der Anode und deren Pluspol über eine in Vorwärtsrichtung geschaltete Diode mit dem einen Anschluß des weiteren Serienschalters verbunden ist.

In jedem Falle ist es bevorzugt, wenn die Schaltung zum Erkennen von Lichtbögen außer dem Leistungsschalter auch den weiteren Schalter ansteuert.

Die Schaltung zum Erkennen von Lichtbögen kann dabei wenigstens eines der folgenden Kriterien auswerten:
- Spannungseinbruch,
- Überschreiten der Maximum-Spannungsgrenze,
- Unterschreiten der Minimum-Spannungsgrenze
- Schneller Stromanstieg,
- Überschreiten der Maximum-Stromgrenze.

Anstelle einer periodischen prophylaktischen Umschaltung mit einer festen Periode, die unabhängig von den Prozeßparametern und der hiervon abhängigen Häufigkeit von Lichtbögen bzw. Durchschlägen ist, ist erfindungsgemäß eine Steuereinheit vorgesehen, die in Art einer adaptiven Regelung die Einschaltdauer der Spannung so einstellt, daß "gerade" kein Lichtbogen bzw. Durchschlag auftritt. Bei dieser Lösung der erfindungsgemäß gestellten Aufgabe ist eine Steuer- bzw. Regeleinheit vorgesehen, die beim Auftreten eines Lichtbogens bzw. Durchschlags diesen durch Abschalten der an die Elektroden angelegten Spannung und Umschalten auf eine Inversspannung für eine bestimmte Zeitdauer (Ausschaltdauer) löscht, und die nach dem Auftreten wenigstens eines Lichtbogens bzw. Durchschlags die Einschaltdauer der einen Plasmabetrieb hervorrufenden Spannung verringert.

Dabei ist es von besonderem Vorteil, wenn die Steuer- bzw. Regeleinheit die Einschaltdauer auf eine Zeitdauer verringert, die kleiner als der aktuelle Zeitabstand zwischen zwei nacheinander auftretenden Lichtbögen bzw. Durchschlägen ist. Da sich die Betriebsparameter einer Anlage während eines Bearbeitungsvorgangs ändern können, ist es weiterhin bevorzugt, wenn die Steuer- bzw. Regeleinheit die Einschaltdauer auch vergrößert:

Hierzu ist es beispielsweise möglich, daß die Steuer- und Regeleinheit die Einschaltdauer vergrößert, wenn über einen bestimmten Zeitraum bzw. über eine bestimmte Zahl von Einschaltperioden kein Lichtbogen bzw. Durchschlag oder nur eine bestimmte Zahl von Lichtbögen bzw. Durchschlägen aufgetreten ist. Die Steuer- und Regeleinheit kann die Einschaltdauer dabei bis zum CW-Betrieb verlängern.

Um das zufällige Auftreten von Arcs bei der adaptiven Regelung nicht so stark zu gewichten, ist es ferner bevorzugt, wenn die Steuer- bzw. Regeleinheit die Einschaltdauer nur dann verringert, wenn während einer bestimmten Zeit eine gewisse Zahl von Lichtbögen bzw. Durchschlägen aufgetreten ist.

Weiterhin ist es bevorzugt, wenn die Steuer- bzw. Regeleinheit beim Beginn des Plasmabetriebs die an die Elektroden angelegte Spannung entweder dauernd oder für eine bestimmte (vor Beginn des Prozesses vorgebbare) Einschaltdauer einschaltet, dann für eine bestimmte Ausschaltdauer ab- oder bevorzugt umschaltet, und sodann die Spannung wieder einschaltet, und beim Auftreten von Lichtbögen bzw. Durchschlägen die Einschaltdauer der Spannung verringert.

Um die erfindungsgemäße Versorgungseinheit an die unterschiedlichsten Bearbeitungs- bzw. Aufbringvorgänge anpassen zu können, ist es ferner von Vorteil, wenn die anfänglichen Werte der Einschaltdauer und der Ausschaltdauer und/oder die Zahl von Lichtbögen bzw. Durchschlägen sowie die Zeiteinheit, in denen diese Zahl auftritt, einstellbar sind.

In jedem Falle ist es ferner von Vorteil, wenn die Einschaltdauer mit der Häufigkeit des Auftretens von Lichtbögen bzw. Durchschlägen über eine variable Kennlinie verknüpft ist, die von weiteren Prozeßparametern abhängig sein kann.

Um die Reduzierung der Leistung der Plasmaanlage so gering wie möglich zu halten, ist es ferner von Vorteil, wenn die Steuer- bzw. Regeleinheit die Ausschaltdauer bzw. die Umschaltdauer optimiert. Die Aus- bzw. Umschaltdauer wird dabei "gerade" so lang eingestellt, daß der Lichtbogen bzw. Durchschlag (Arc) "nachhaltig" gelöscht wird.

### Kurze Beschreibung der Zeichnung

Die Erfindung wird nachstehend unter Bezugnahme auf die Zeichnung näher beschrieben, in der zeigen:
- Fig. 1: die Schaltung eines ersten Beispiels,
- Fig. 2: ein Spannungs/Zeit-Diagramm zur Erläuterung der Funktionsweise der in Fig. 1 gezeigten Schaltung,
- Fig. 3: die Schaltung eines zweiten Beispiels,
- Fig. 4: ein Spannungs/Zeit-Diagramm zur Erläuterung der Funktionsweise der in Fig. 3 gezeigten Schaltung,
- Fig. 5: ein Spannungs/Zeit-Diagramm zur Erläuterung der Funktionsweise einer Modifikation der in Fig. 3 gezeigten Schaltung,
- Fig. 6: die Schaltung eines dritten Beispiels,
- Fig. 7: ein Spannungs/Zeit-Diagramm zur Erläuterung der Funktionsweise des dritten Beispiels, und
- Fig. 8: ein Blockschaltbild eines Ausführungsbeispiels der Erfindung, und
- Fig. 9: eine Darstellung zur Erläuterung der Funktionsweise des vierten Ausführungsbeispiels.

### Darstellung von Biespielen und Ausführungsbeispielen

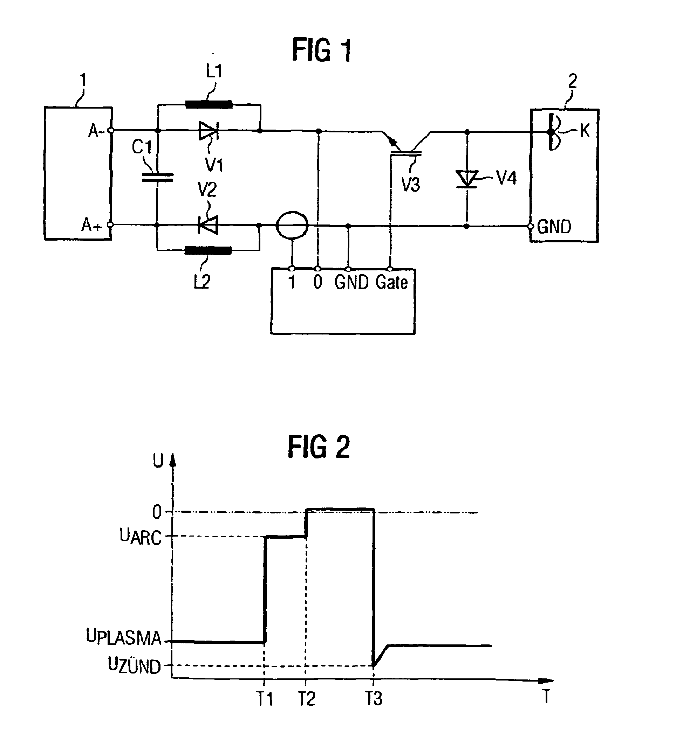

Fig. 1 zeigt ein erstes Beispiel. Die Energieversorgungseinheit weist ein Schaltregler-Netzteil 1 auf, das beispielsweise (d.h. ohne Beschränkung der Allgemeinheit) eine Gleichspannung von ca. 400 V liefert. Der negative Ausgangsanschluß A- des Netzteils 1 ist über eine Induktivität L1 und einen als Serienschalter ausgebildeten Leistungsschalter V3 mit einer Kathode K in einer Plasmakammer 2 verbunden, deren Gehäuse geerdet ist. Der Serienschalter 1 ist bei dem gezeigten Beispiel ein IGBT. Der positive Ausgangsanschluß A+ des Netzteils 1 ist über eine Induktivität L2 mit dem Gehäuse der Plasmakammer 2 verbunden. Dies ist symbolisch mit GND bezeichnet.

Parallel zu den Induktivitäten L1 und L2 sind Dioden V1 bzw. V2 geschaltet, die derart gepolt sind, daß sie beim Plasmabetrieb sperren.

Ferner ist zwischen die Ausgangsanschlüsse A- und A+ ein Kondensator C1 geschaltet. Zwischen den Kathodenanschluß und GND ist eine Diode V4 geschaltet, die beim Plasmabetrieb in Sperrrichtung gepolt ist.

Weiterhin ist eine Schaltung 3 zum Erkennen von Lichtbögen bzw. Durchschlägen vorgesehen, die den Serienschalter V3 über den Ausgangsanschluß "Gate" steuert. Um einen Lichtbogen - auch als Arc bezeichnet - zu erkennen, mißt die Schaltung 3 den fließenden Strom I und die Spannung U und wertet die gemessenen Größen nach folgenden Kriterien aus:
- Spannungseinbruch,
- Überschreiten der Maximum-Spannungsgrenze,
- Unterschreiten der Minimum-Spannungsgrenze
- Schneller Stromanstieg,
- Überschreiten der Maximum-Stromgrenze.

Beim Erkennen eines Lichtbogens wird der Leistungsschalter V3 von der Schaltung 3 geöffnet, so daß der Stromfluß zwischen dem Netzteil 1 und den Elektroden der Plasmakammer 2 unterbrochen wird. Beim Öffnen des Leistungsschalters polt die Spannung an den Zuleitungsinduktivitäten zur Plasmakammer 2 um; um zu vermeiden, daß dies zu Spannungsspitzen führt, werden die Elektroden über die Diode V4 kurzgeschlossen und die in den Zuleitungsinduktivitäten gespeicherte Energie abgebaut. Die Dioden V1 und V2 verhindern zum einen, daß die Spannungen an den Induktivitäten L1 und L2 beim Öffnen des Leistungsschalters ansteigen und bewirken gleichzeitig, daß der Strom in den Induktivitäten nur sehr langsam abnimmt. Die Induktivitäten L1 und L2 können auch magnetisch gekoppelt sein. Der Kondensator C1 dient zur Vermeidung von Spannungsspitzen, die durch die Zuleitungsinduktivitäten auftreten können.

Im folgenden soll die Funktionsweise der in Fig. 1 gezeigten elektrischen Versorgungseinheit unter Bezugnahme auf Fig. 2, in der ein Spannungs/Zeit-Diagramm dargestellt ist, näher beschrieben werden: Zum Zeitpunkt T1 bricht die Spannung U aufgrund eines Lichtbogens auf die für einen Lichtbogen bzw. Durchschlag typische Spannung UARC ein. Nach der einstellbaren Verzögerungszeit T1-T2 wird der Schalter V3 geöffnet und die Energiezufuhr unterbrochen. Nach der einstellbaren Lichtbogen-Pause T2-T3 wird der Schalter V3 wieder geschlossen, die Spannung steigt bis auf die Zündspannung UZÜND an und bricht wieder auf die Brennspannung UPLASMA zurück.

Durch die Freilaufdioden V1 und V2 wird der Generator-Ausgangsstrom zum Zeitpunkt des Abschaltens gespeichert, so daß beim Wiedereinschalten der ursprüngliche Betriebszustand sehr schnell wieder erreicht wird.

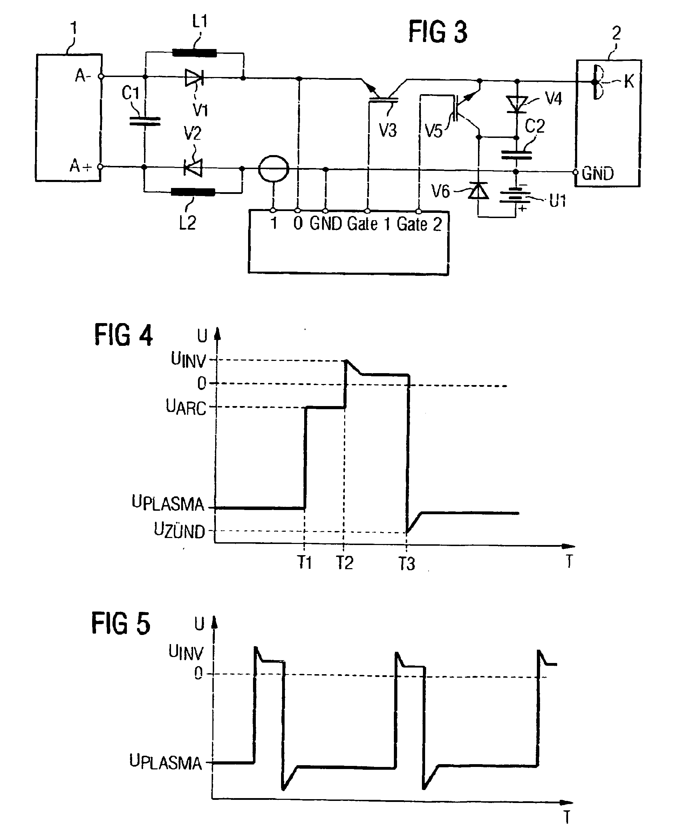

Fig. 3 zeigt eine Modifikation des in Fig. 1 gezeigten Beispiels. Dabei sind gleiche Teile wie in Fig. 1 mit den selben Bezugszeichen versehen, so daß auf eine erneute Vorstellung verzichtet wird.

Bei diesem Beispiel ist in Reihe mit der Diode V4 ein Kondensator C2 geschaltet. Zwischen den Anschluß der Kathode K und den Verbindungspunkt Diode V4/Kondensator C2 ist ein weiterer Serienschalter V5 geschaltet, der ebenfalls von der Schaltung 3 über den Ausgangsanschluß Gate2 angesteuert wird.

Weiterhin kann optional eine Inversspannungsquelle vorgesehen sein, die eine (Hilfs)-Gleichspannungsquelle U1 aufweist, die typischerweise eine Spannung von etwa 30 V liefert. Der Minuspol der Gleichspannungsquelle U1 ist mit der Anode verbunden, während der Pluspol der Gleichspannungsquelle U1 über eine im Vorwärtsrichtung geschaltete Diode V6 mit dem einen Anschluß des weiteren Serienschalters V5 verbunden ist.

Im folgenden wird die Funktionsweise des in Fig. 3 gezeigten Beispiels unter Bezugnahme auf Fig. 4 näher erläutert, die ein Spannungs/ZeitDiagramm zeigt.

Beim Auftreten eines Lichtbogens (Zeitpunkt T1) bricht die Spannung von der Plasma-Spannung UPlasma auf die Lichtbogen-Spannung UArc zusammen. Daraufhin öffnet die Schaltung 3 den Leistungsschalter V3. Durch den mit der Diode V4 in Reihe geschalteten Kondensator C2 wird die sich aus der Leitungsinduktivität und dem Strom ergebende Energie als Spannung in den Kondensator C2 umgeladen. Zum Zeitpunkt T2 wird diese Spannungen als Inversspannung an die Elektroden der Plasmakammer 2 angelegt, so daß der Lichtbogen wesentlich schneller als ohne aktive Löschung gelöscht wird. Durch die optionale Spannungsquelle U1 kann die angelegte Inversspannung erhöht werden.

Versieht man die Schaltung 3 mit einem zusätzlichen Pulsgenerator, so kann die an die Plasmakammer angelegte Spannung nicht nur beim Auftreten eines Arcs, sondern regelmäßig für einen kurzen Moment umgepolt werden. Hierdurch kann die Wahrscheinlichkeit für die Entstehung von Lichtbögen wesentlich verringert werden bzw. Lichtbögen können schon in der Entstehung wieder gelöscht werden.

Zusätzlich wird verhindert, daß sich beim reaktiven Sputtern Oxidschichten auf dem Target bilden; weiterhin können oxidierte Targets freigesputtert werden.

Fig. 5 zeigt schematisch den Spannungsverlauf für diese Modifikation des in Fig. 3 gezeigten Beispiels. Die Pulsfrequenzen können je nach verwendetem Leistungsschalter bis zu 100 kHz betragen.

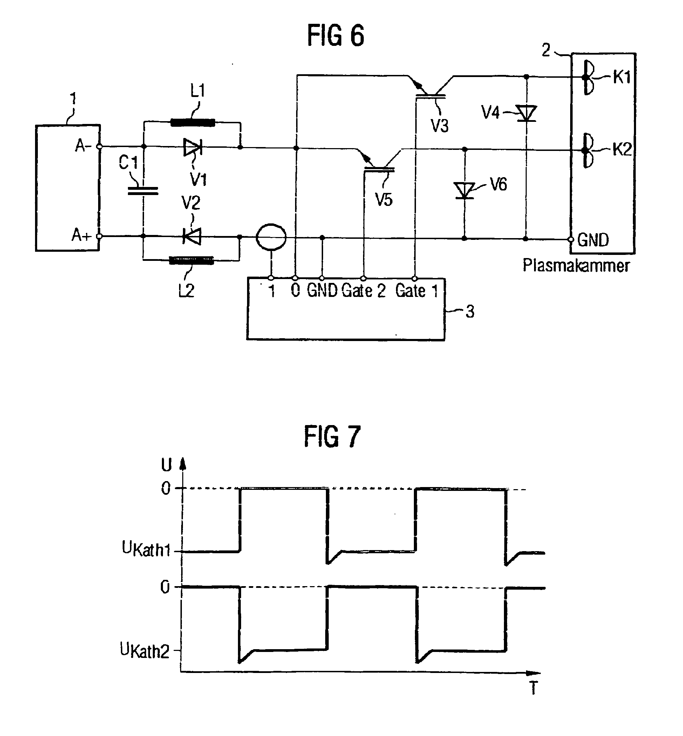

Fig. 6 zeigt die Schaltung eines dritten Beispiels, bei der in der Plasmakammer 2 zwei Kathoden K1 und K2 angeordnet sind, denen jeweils eigene Leistungsschalter V3 und V5 und Dioden V4 und V6 zugeordnet sind.

Durch gleichzeitiges Einschalten der Leistungsschalter V3 und V5 arbeiten die beiden Kathoden im Parallelbetrieb. Werden die beiden Schalter abwechselnd eingeschaltet, kann durch Variationen der Einschaltzeiten die effektive Leistung der Kathoden geregelt werden. Es sind Umschaltfrequenzen bis zu mehreren kHz möglich.

Fig. 7 zeigt ein Spannungs/Zeit-Diagramm, in dem das alternierende Einschalten der beiden Schalter schematisch dargestellt ist. Selbstverständlich können auch mehr als zwei Kathoden eingesetzt werden.

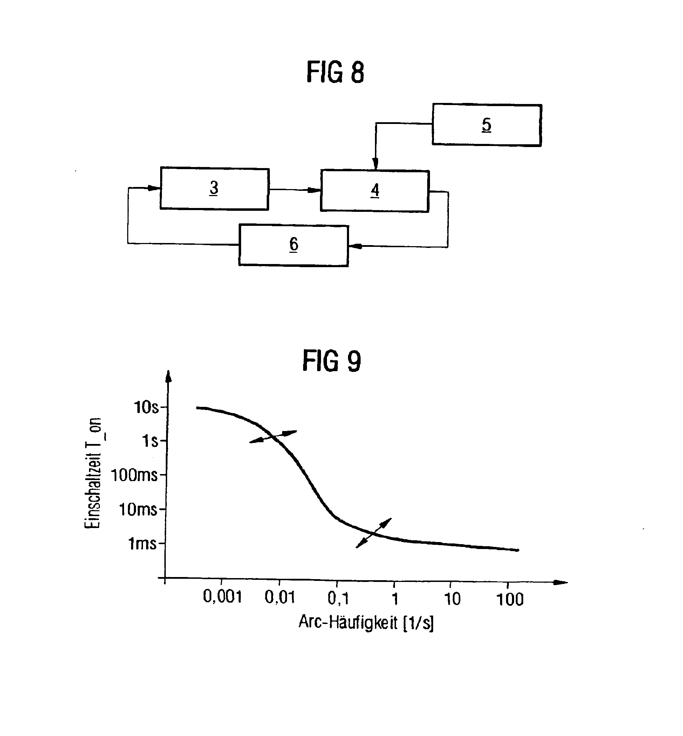

Fig. 8 zeigt ein Ausführungsbeispiel der Erfindung, bei dem die Leistungsminderung, die sich bei der Vorgehensweise gemäß Fig. 5 durch das prophylaktische Umschalten der Spannung mit einer festen, vorgegebenen Frequenz ergibt, deutlich reduziert wird: Bei diesem Ausführungsbeispiel ist die Schaltung 3 durch eine adaptive Regeleinheit 4 mit einer Startwert-vorgabeeinheit 5 ergänzt.

Aufgrund der Verwendung einer adaptiven Regeleinheit 4 ist die Einschaltdauer der an die Elektroden angelegten Spannung nicht fest vorgegeben. Im laufenden Betrieb wird durch die adaptive Regeleinheit 4 eine möglichst hohe Einschaltdauer eingestellt, um den Plasmaprozeß in einer Plasmaanlage 6 nicht durch unnötige Austastung - wie gemäß Fig. 5 und 7 zu unterbrechen. Treten jedoch Arcs auf, so wird nach dem Löschen des Arcs die Einschaltdauer verkürzt. Damit wird die Wahrscheinlichkeit für das Auftreten eines wiederholten Arcs geringer. Tritt trotz der verkürzten Einschaltdauer weiterhin ein Arc auf, wird die Einschaltdauer weiter verkürzt, bis ein stabiler, Arc-freier Betrieb möglich ist. Entsprechend wird die Einschaltdauer verlängert, wenn über eine bestimmte Zeit keine Arcs aufgetreten sind. Die Einschaltdauer wird dann so lange verlängert, bis wiederum Arcs im Prozeß auftreten. Die Verlängerung der Einschaltdauer kann soweit gehen, daß die Anlage im "continous-Betrieb" (CW-Betrieb) gefahren wird.

Die Einschaltzeit und die Arc-Häufigkeit können über eine variable Kennlinie der adaptiven Regeleinheit, die von weiteren Prozeßparametern - Prozeßgase, Target- und Sputtermaterialien usw. - abhängig sein kann, miteinander verknüpft bzw. korreliert werden. Fig. 9 zeigt qualitativ eine Kennlinie, die die auf der Abzisse aufgetragene Arc-Häufigkeit (1/s) mit der auf der Ordinate aufgetragenen Einschaltzeit (s) korreliert. Ausdrücklich wird darauf hingewiesen, daß entsprechende Kennlinien nicht nur von mehreren Parametern, sondern auch von der Geometrie der Plasmaanlage, den Prozeßmaterialien usw. abhängen. Bevorzugt werden die Kennlinien empirisch ermittelt und/oder von der Regeleinheit 4, die beispielsweise einen Mikroprozessor aufweisen kann, adaptiv eingestellt.

Über die Startwert-Vorgabeeinheit 5 können bestimmte, als vorteilhaft erkannte Werte für die Einschaltdauer sowie die Aus- bzw. Umschaltdauer beim Beginn des Plasmabetriebs vorgegeben oder bestimmte bereits ermittelte Kennlinie gewählt werden.

Durch die Verwendung eines adaptiven Regelalgorithmus werden die Parameter des Arc-Managements an die Prozeßparameter optimal angepaßt. Dabei ist es insbesondere auch möglich, die Aus- bzw. Umschaltdauer optimal - gegebenenfalls auch adaptiv - einzustellen.

Die Erfindung ist vorstehend anhand von Beispielen und einem Ausführungsbeispiel ohne Beschränkung der Allgemeinheit beschrieben worden. Insbesondere kann die erfindungsgemäße Versorgungseinheit für alle aus der einleitend genannten Literatur bekannten Anwendungen eingesetzt werden. Weiterhin ist es möglich, den Pulsbetrieb oder die adaptive Regelung, die aktive Löschung von Lichtbögen und das Umschalten zwischen zwei oder mehr Kathoden teilweise oder vollständig miteinander zu kombinieren oder zwischen den einzelnen beschriebenen Betriebsmodi umzuschalten.

## Patentansprüche

1. Elektrische Versorgungseinheit für Plasmaanlagen (2), wie Plasma-Bearbeitungs- bzw. Beschichtungsvorrichtungen, bei denen es zum Auftreten von Lichtbögen bzw. Durchschlägen kommen kann, mit einer Gleichspannungs- bzw. Gleichstromquelle (1), deren Ausgangsanschlüsse (A-, A+) über wenigstens eine Induktivität (L1, L2) und einen Leistungsschalter (V3) mit den Elektroden (K, GND) der Plasmaanlage verbunden sind, wobei eine Steuer- bzw. Regeleinheit (4) vorgesehen ist, die dazu ausgelegt ist, nach dem Auftreten wenigstens eines Lichtbogens bzw. Durchschlags die Einschaltdauer der einen Plasmabetrieb hervorrufenden Spannung zu verringern, und wobei eine Vorgabeeinheit (5) vorgesehen ist, mit der Startwerte und/oder Kennlinien einstellbar sind,
**dadurch gekennzeichnet, dass**
der Leistungsschalter (V3) in Serie zwischen der Gleichspannungs- bzw. Gleichstromquelle (1) und wenigstens einer Elektrode (K, GND) der Plasmaanlage geschaltet ist und die Steuer- bzw. Regeleinheit (4) dazu ausgelegt ist, beim Auftreten eines Lichtbogens bzw. Durchschlags (Arcs) diesen durch Abschalten der an die Elektroden angelegten Spannung und Umschalten auf eine Inverspannung für eine bestimmte, als Ausschaltdauer bezeichnete Zeitdauer zu löschen.

2. Elektrische Versorgungseinheit für Plasmaanlagen nach Anspruch 1,
weiter **dadurch gekennzeichnet, dass**
die Steuer- bzw. Regeleinheit die Einschaltdauer auf eine Zeitdauer verringert, die kleiner als der aktuelle Zeitabstand zwischen zwei nacheinander auftretenden Lichtbögen bzw. Durchschlägen ist.

3. Elektrische Versorgungseinheit für Plasmaanlagen nach Anspruch 1 oder 2,
weiter **dadurch gekennzeichnet, dass**
die Steuer- bzw. Regeleinheit die Einschaltdauer nur dann verringert, wenn während einer bestimmten Zeit eine gewisse Zahl von Lichtbögen bzw. Durchschlägen aufgetreten ist.

4. Elektrische Versorgungseinheit für Plasmaanlagen nach einem der vorhergehenden Ansprüche,
weiter **dadurch gekennzeichnet, dass**
die Steuer- und Regeleinheit dazu ausgelegt ist, die Einschaltdauer zu vergrößern, wenn über einen bestimmten Zeitraum bzw. über eine bestimmte Zahl von Einschaltperioden kein Lichtbogen bzw. Durchschlag oder nur eine bestimmte Zahl von Lichtbögen bzw. Durchschlägen aufgetreten ist.

5. Elektrische Versorgungseinheit für Plasmaanlagen nach Anspruch 4,
weiter **dadurch gekennzeichnet, dass**
die Steuer- und Regeleinheit die Einschaltdauer bis zum CW-Betrieb verlängern kann.

6. Elektrische Versorgungseinheit für Plasmaanlagen nach einem der vorhergehenden Ansprüche,
weiter **dadurch gekennzeichnet, dass**
die Steuer- bzw. Regeleinheit (4) dazu ausgelegt ist, beim Beginn des Plasmabetriebs die an die Elektroden (Kathode K, GND) angelegte Spannung entweder dauernd oder für eine bestimmte Einschaltdauer einzuschalten, dann für eine bestimmte Ausschaltdauer ab- oder bevorzugt umzuschalten, und sodann die Spannung wieder einzuschalten, und daß die Steuer- bzw. Regeleinheit beim Auftreten von Lichtbögen bzw. Durchschlägen die Einschaltdauer der Spannung verringert.

7. Elektrische Versorgungseinheit für Plasmaanlagen nach einem der vorhergehenden Ansprüche,
weiter **dadurch gekennzeichnet, dass**
die anfänglichen Werte der Einschaltdauer und der Ausschaltdauer und/oder die Zahl von Lichtbögen bzw. Durchschlägen sowie die Zeiteinheit, in denen diese Zahl auftritt, einstellbar sind.

8. Elektrische Versorgungseinheit für Plasmaanlagen nach einem der vorhergehenden Ansprüche,
weiter **dadurch gekennzeichnet, dass**
die Einschaltdauer mit der Häufigkeit des Auftretens von Lichtbögen bzw. Durchschlägen über eine variable Kennlinie verknüpft ist, die von weiteren Prozeßparametern abhängig sein kann.

9. Elektrische Versorgungseinheit für Plasmaanlagen nach einem der vorhergehenden Ansprüche,
weiter **dadurch gekennzeichnet, dass**
die Steuer- bzw. Regeleinheit dazu ausgelegt ist, die Ausschaltdauer zu optimieren, indem sie die Ausschaltdauer gerade so lang einstellt, daß der Lichtbogen bzw. Durchschlag (Arc) nachhaltig gelöscht wird.

10. Elektrische Versorgungseinheit für Plasmaanlagen nach einem der vorhergehenden Ansprüche,
weiter **dadurch gekennzeichnet, dass**
die Steuer- bzw. Regeleinheit (4) Bestandteil der Schaltung (3) zum Erkennen von Lichtbögen ist.

11. Elektrische Versorgungseinheit für Plasmaanlagen nach einem der vorhergehenden Ansprüche,
weiter **dadurch gekennzeichnet, dass**
die Steuer- bzw. Regeleinheit (4) zwischen wenigstens zwei der Betriebsmodi schnelles Abschalten nur beim Auftreten von Arcs, periodisches Aus- bzw. Umschalten und adaptive Regelung umschaltbar ist.

12. Verfahren zum Betrieb einer elektrischen Versorgungseinheit für Plasmaanlagen, wie Plasma-Bearbeitungs- bzw. Beschichtungsvorrichtungen, bei denen es zum Auftreten von Lichtbögenbzw. Durchschlägen kommen kann, mit einer Gleichspannungs- bzw. Gleichstromquelle, deren Ausgangsanschlüsse über wenigstens eine Induktivität und einen Leistungsschalter mit den Elektroden der Plasmaanlage verbunden sind,
**dadurch gekennzeichnet, dass**
der Leistungsschalter in Serie zwischen der Gleichspannungs- bzw. Gleichstromquelle und wenigstens einer Elektrode der Plasmaanlage geschaltet ist, beim Auftreten eines Lichtbogens bzw. Durchschlags dieser durch Abschalten der an die Elektroden angelegten Spannung und Umschalten auf eine Inversspannung für eine bestimmte, als Ausschaltdauer bezeichnet Zeitdauer gelöscht wird, und dass nach dem Auftreten wenigstens eines Lichtbogens bzw. Durchschlags die Einschaltdauer der einen Plasmabetrieb hervorrufenden Spannung verringert wird und dass Startwerte und/oder Kennlinien mit einer Vorgabeeinheit (5) einstellbar sind.

13. Verfahren nach Anspruch 12,
weiter **dadurch gekennzeichnet, dass**
die Einschaltdauer auf eine Zeitdauer verringert wird, die kleiner als der aktuelle Zeitabstand zwischen zwei nacheinander auftretenden Lichtbögen bzw. Durchschlägen ist.

14. Verfahren nach Anspruch 12 oder 13,
weiter **dadurch gekennzeichnet, dass**
die Einschaltdauer vergrößert wird, wenn über einen bestimmten Zeitraum bzw. über eine bestimmte Zahl von Einschaltperioden kein Lichtbogen bzw. Durchschlag oder nur eine bestimmte Zahl von Lichtbögen bzw. Durchschlägen aufgetreten ist.

## Claims

1. An electric supply unit for plasma systems (2) such as plasma-processing or plasma-coating apparatuses, in which electric arcs or disruptive discharges may occur, with a DC voltage or DC current source (1) whose output terminals (A-, A+) are connected to the electrodes (K, GND) of the plasma system via at least one inductance (L1, L2) and one power switch (V3), wherein an open-loop or closed-loop control unit (4) is provided, which is configured to reduce the voltage causing plasma operation after the occurrence of at least one arc or disruptive discharge, and wherein a setpoint selection unit (5) is provided with which the starting values and/or characteristic curves can be set, **characterized in that** the power switch (V3) is connected in series between the DC voltage or DC current source (1) and at least one electrode (K, GND) of the plasma system, and the open-loop or closed-loop control unit (4) is configured during the occurrence of an arc or disruptive discharge to quench said arc or discharge by cutting off the voltage applied to the electrodes and switching over to an inverse voltage for a specific duration designated as off- time.

2. An electric supply unit for plasma systems according to claim 1, further **characterized in that** the open-loop or closed-loop control unit reduces the on-time to such a duration which is shorter than the current time interval between two successively occurring arcs or disruptive discharges.

3. An electric supply unit for plasma systems according to claim 1 or 2, further **characterized in that** the open-loop or closed-loop control unit only reduces the on- time when a specific number of arcs or disruptive discharges has occurred during a specific period of time.

4. An electric supply unit for plasma systems according to one of the preceding claims, further **characterized in that** the open-loop or closed-loop control unit is further configured to extend the on- time when no arc or disruptive discharge has occurred, or only a specific number of arcs or disruptive discharges over a specific period of time or over a specific number of operating periods.

5. An electric supply unit for plasma systems according to claim 4, further **characterized in that** the open-loop or closed-loop control unit can extend the on-time until CW operation.

6. An electric supply unit for plasma systems according to one of the preceding claims, further **characterized in that** the open-loop or closed-loop control unit (4) is further configured to activate the voltage applied to the electrodes (cathode K, GND) at the beginning of plasma operation either permanently or for a specific on- time, and then cuts off said voltage for a specific cut-off period or preferably switches it over, and thereafter activates the voltage again, and the open-loop or closed-loop control unit reduces the on- time of the voltage following the occurrence of arcs or disruptive discharges.

7. An electric supply unit for plasma systems according to one of the preceding claims, further **characterized in that** the initial values of the on- time and the cut-off time and/or the number of arcs or disruptive discharges and the unit of time in which this number occurs are adjustable.

8. An electric supply unit for plasma systems according to one of the preceding claims, further **characterized in that** the on- time is linked to the frequency of the occurrence of arcs and disruptive discharges by way of a variable characteristic curve which can depend on further process parameters.

9. An electric supply unit for plasma systems according to one of the preceding claims, further **characterized in that** the open-loop or closed-loop control unit is further configured to optimize the cut-off period **in that** it sets the cut-off period precisely to such a long period of time that the arc or disruptive discharge is sustainably quenched.

10. An electric supply unit for plasma systems according to one of the preceding claims, further **characterized in that** the open-loop or closed-loop control unit (4) is a part of the circuit (3) for recognizing arcs.

11. An electric supply unit for plasma systems according to one of the preceding claims, further **characterized in that** the open-loop or closed-loop control unit (4) can be switched over between at least two of the operating modes of rapid cut-off only during the occurrence of arcs, periodic cut-off or changeover, and adaptive closed-loop control.

12. A method for operating an electric supply unit for plasma systems such as plasma-processing or plasma-coating apparatuses, in which electric arcs or disruptive discharges may occur, comprising a DC voltage or DC current source whose output terminals are connected to the electrodes of the plasma system via at least one inductance and one power switch, **characterized in that** the power switch is switched in series between the DC voltage or DC current source and at least one electrode of the plasma system, and during the occurrence of an arc or disruptive discharge said arc or discharge is quenched by cutting off the voltage applied to the electrodes and switching over to an inverse voltage for a specific duration designated asoff- time, and after the occurrence of at least one arc or disruptive discharge the on- time of a voltage causing plasma operation is reduced, and the starting values and/or characteristic curves are adjustable with a setpoint selection unit (5).

13. A method according to claim 12, further **characterized in that** the on- time is reduced to a duration which is shorter than the current time interval between two successively occurring arcs or disruptive discharges.

14. A method according to claim 12 or 13, further **characterized in that** the on- time is extended when no arc or disruptive discharge or only a specific number of arcs or disruptive discharges has occurred over a specific period of time or a specific number of operating periods.

## Revendications

1. Unité d'alimentation électrique pour installations à plasma (2), telles que des unités de traitement ou de revêtement à plasma, dans lesquelles des arcs électriques ou des décharges peuvent se produire, avec une source de tension continue ou de courant continu (1) dont les connexions de sortie (A-, A+) sont reliées aux électrodes (K, GND) de l'installation à plasma par l'intermédiaire d'au moins une inductance (L1, L2) et d'un interrupteur interrupteurde puissance (V3), avec une unité de commande et de régulation (4) conçue pour réduire la durée d'activation de la tension produisant un mode plasma après l'apparition d'au moins un arc électrique ou une décharge, une unité de consigne (5) étant prévue pour pouvoir définir des valeurs de départ et/ou des courbes caractéristiques, **caractérisée en ce que** le interrupteur de puissance (V3) est monté en série entre la source de tension continue ou de courant continu (1) et au moins une électrode (K, GND) de l'installation à plasma et l'unité de commande et de régulation (4) est conçue pour, en cas d'apparition d'un arc électrique ou d'une décharge, éteindre celui-ci en coupant la tension appliquée aux électrodes et en commutant vers une tension inverse pendant une durée déterminée, appelée durée de désactivation.

2. Unité d'alimentation électrique pour installations à plasma selon la revendication 1, **caractérisée en outre en ce que** l'unité de commande et de régulation réduit la durée d'activation à une durée inférieure à l'intervalle de temps actuel entre deux arcs électriques ou décharges successifs.

3. Unité d'alimentation électrique pour installations à plasma selon la revendication 1 ou 2, **caractérisée en outre en ce que** l'unité de commande et de régulation ne réduit la durée d'activation que lorsqu'un certain nombre d'arcs électriques ou de décharges s'est produit pendant un temps donné.

4. Unité d'alimentation électrique pour installations à plasma selon l'une des revendications précédentes, **caractérisée en outre en ce que** l'unité de régulation et de commande est conçue pour augmenter la durée d'activation quand aucun arc électrique ou aucune décharge ne s'est produit ou seulement un certain nombre d'arcs électriques ou de décharges pendant un laps de temps donné ou pendant un certain nombre de périodes d'activation.

5. Unité d'alimentation électrique pour installations à plasma selon la revendication 4, **caractérisée en outre en ce que** l'unité de commande et de régulation peut allonger la durée d'activation jusqu'au fonctionnement en mode CW.

6. Unité d'alimentation électrique pour installations à plasma selon l'une des revendications précédentes, **caractérisée en outre en ce que** l'unité de commande et de régulation (4) est conçue pour activer la tension appliquée aux électrodes (cathode K, GND) soit en permanence, soit pendant une certaine durée d'activation au début du mode plasma, puis la désactiver et de préférence la commuter, puis activer à nouveau la tension, et **en ce que** l'unité de commande et de régulation réduit la durée d'activation de la tension en cas d'arcs électriques ou de décharges.

7. Unité d'alimentation électrique pour installations à plasma selon l'une des revendications précédentes, **caractérisée en outre en ce que** les valeurs initiales de la durée d'activation et de la durée de désactivation et/ou le nombre d'arcs électriques ou de décharges ainsi que l'unité de temps pendant laquelle ce nombre se produit sont réglables.

8. Unité d'alimentation électrique pour installations à plasma selon l'une des revendications précédentes, **caractérisée en outre en ce que** la durée d'activation est liée à la fréquence d'apparition des arcs électriques ou des décharges par une courbe caractéristique variable qui peut dépendre d'autres paramètres de processus.

9. Unité d'alimentation électrique pour installations à plasma selon l'une des revendications précédentes, **caractérisée en outre en ce que** l'unité de commande et de régulation est conçue pour optimiser la durée de désactivation en la réglant de façon qu'elle soit juste assez longue pour que l'arc électrique ou la décharge soit durablement éteint.

10. Unité d'alimentation électrique pour installations à plasma selon l'une des revendications précédentes, **caractérisée en outre en ce que** l'unité de commande et de régulation (4) fait partie du circuit (3) pour la détection des arcs électriques.

11. Unité d'alimentation électrique pour installations à plasma selon l'une des revendications précédentes, **caractérisée en outre en ce que** l'unité de commande et de régulation (4) peut commuter entre au moins deux des modes fonctionnement comprenant une désactivation rapide uniquement en présence d'arcs, une a désactivation et activation périodique et une régulation adaptative.

12. Procédé pour le pilotage d'une unité d'alimentation électrique pour installations à plasma, telles que des unités de traitement ou de revêtement à plasma, dans lesquelles des arcs électriques ou des décharges peuvent se produire, avec une source de tension continue ou de courant continu dont les connexions de sortie sont reliées aux électrodes de l'installation à plasma par l'intermédiaire d'au moins une inductance et d'un interrupteur de puissance, **caractérisé en ce que** le interrupteur de puissance est monté en série entre la source de tension continue ou de courant continu et au moins une électrode de l'installation à plasma, lorsqu'un arc électrique ou une décharge se produit, il est éteint par la désactivation de la tension appliquée aux électrodes et la commutation à une tension inverse pendant une certaine durée, appelée durée de désactivation, et **en ce qu'**après l'apparition d'au moins un arc électrique ou d'une décharge, la durée d'activation de la tension produisant le mode plasma est réduite et **en ce que** des valeurs initiales et/ou des courbes caractéristiques peuvent être réglées à une valeur de consigne (5).

13. Procédé selon la revendication 12, **caractérisé en outre en ce que** la durée d'activation est réduite à une durée inférieure à l'intervalle de temps effectif entre deux arcs électriques ou décharges successifs.

14. Procédé selon la revendication 12 ou 13, **caractérisé en outre en ce que** la durée d'activation est augmentée quand aucun arc électrique ou aucune décharge ne s'est produit ou seulement un certain nombre d'arcs électriques ou de décharges pendant un laps de temps donné ou pendant un certain nombre de périodes d'activation.
